# EUROPÄISCHE PATENTSCHRIFT

(11) **EP 1 198 833 B1**
(45) Veröffentlichungstag und Bekanntmachung des Hinweises auf die Patenterteilung: **09.05.2007**
(21) Anmeldenummer: 00956113.5
(22) Anmeldetag: 27.07.2000
(51) Int. Cl.: H01L 21/8242

(54) **VERFAHREN ZUR HERSTELLUNG EINES HALBLEITERSPEICHERBAUELEMENTS**
METHOD FOR PRODUCING A SEMICONDUCTOR MEMORY ELEMENT
PROCEDE DE FABRICATION D'UN COMPOSANT MEMOIRE A SEMI-CONDUCTEUR

(30) Priorität: 27.07.1999 DE 19935130
(43) Veröffentlichungstag der Anmeldung: 24.04.2002
(73) Patentinhaber: Qimonda AG, 81739 München (DE)
(72) Erfinder: ENGELHARDT, Manfred, D-83620 Feldkirchen-Westerham (DE); WEINRICH, Volker, D-81373 München (DE)
(74) Vertreter: Barth, Stephan Manuel
(86) Internationale Anmeldenummer: PCT/DE2000/002555
(87) Internationale Veröffentlichungsnummer: WO 2001/008215

(56) Entgegenhaltungen:
- WO-A-97/06556
- DE-A- 19 640 211
- US-A- 5 478 768
- US-A- 5 914 851
- PATENT ABSTRACTS OF JAPAN vol. 1996, no. 01, 31. Januar 1996 (1996-01-31) & JP 07 240389 A (MITSUBISHI ELECTRIC CORP), 12. September 1995 (1995-09-12)

## Beschreibung

Die Erfindung betrifft ein Verfahren zur Herstellung eines Kontaktlochs für ein Halbleiterspeicherbauelement, insbesondere ein DRAM oder ein FRAM, mit einem Siliziumsubstrat, einer auf diesem angeordneten Zwischendielektrikumschicht, auf welcher eine obere Schicht aus einem ferroelektrischen Material oder aus einem Material hoher Dielektrizitätskonstante angeordnet ist.

Abhängig vom Chip-Design bzw. dem Chip-Layout ist in einem hochintegrierten DRAM bzw. FRAM bei Verwendung von Materialien mit hoher Dielektrizitätskonstante, beispielsweise BST (BST steht für Barium-Strontium-Titanat) und von ferroelektrischen Materialien, beispielsweise SBT (SBT steht für Strontium-Wismuth-Tantalat) erforderlich, bei der Plasmaätzung des Kontaktlochs zum Siliziumsubstrat durch diese Materialien hindurchzuätzen. Eine Kontamination des am Boden des Kontaktlochs freiliegenden monokristallinen Siliziumsubstrats muß dabei vermieden werden, um eine negative Beeinflussung des Auswahltransistors von DRAM bzw. FRAM zu verhindern.

Zu diesem Zweck ist es bekannt, zwei Lithographie-Prozeßschritte bzw. zwei Lithographie-Ebenen durchzuführen. Im ersten Lithographie-Prozeßschritt wird dabei durch Plasmaätzen mittels Lackmaske ein Fenster in der ferroelektrischen Schicht erzeugt. Im zweiten Lithographie-Prozeßschritt wird das eigentliche Kontaktloch daraufhin bis zum Siliziumsubstrat hinunter mittels einer neuen kleineren Lackmaske geätzt. Dieses herkömmliche Verfahren führt zwar zum Ziel, eine Kontamination des Kontaktlochbodens zu vermeiden, es ist jedoch aufgrund des Einsatzes von zwei Lithographie-Prozeßschritten bzw. Lithographie-Ebenen sehr aufwendig.

Aus DE-A-19 640 211 ist ein Verfahren zur Herstellung eines Kontaktloches für ein Halbleiterspeicherbauelement bekannt.

Die DE 43 40 419 C2 offenbart ein Herstellungsverfahren für eine Halbleitervorrichtung mit einer Isolierschicht, in der ein Kontaktloch gebildet wird. Bei diesem bekannten Verfahren wird auf der Isolierschicht eine Fotolack-Lochmaske gebildet und durch anisotropes Ätzen ein Teil des Kontaktlochs unter Belassung einer Restschichtdicke der Isolierschicht gebildet. Weiterhin wird die Fotolackmaske entfernt und eine TEOS-Schicht auf der resultierenden Struktur abgeschieden. Dann erfolgt ein anisotropes Ätzen der TEOS-Schicht, zur Entfernung der TEOS-Schicht am Boden des Teilkontaktlochs. Anschließend wird das Kontaktloch durch einen Ätzprozeß fertiggestellt, wobei das Kontaktloch eine Konfiguration aufweist, bei der sich der Öffnungsdurchmesser durch die aufwärtige Richtung erhöht.

Aus der DE 195 28 746 C1 ist ein Verfahren zum Erzeugen einer Siliziumdioxid-Schicht auf Oberflächenabschnitten einer Struktur mit Seitenwandabschnitten und einem Bodenabschnitt bekannt.

Eine Aufgabe der vorliegenden Erfindung besteht demnach darin, ein Verfahren der eingangs genannten Art zu schaffen, das mit vereinfachtem, d.h. einem einzigen, Lithographie-Prozeß zum Ziel führt.

Gelöst wird diese Aufgabe durch den Gegenstand des Anspruchs 1. Vorteilhafte Weiterbildungen der Erfindung sind in den Unteransprüchen angegeben.

Mit anderen Worten basiert das erfindungsgemäße Verfahren auf der Verwendung einer hochtemperaturbeständigen organischen Maskenschicht, vorzugsweise aus Polyimid oder Photoimid und in der Teilätzung der Dielektrizitätsmaterialschicht (Zwischenoxid) im Verbund mit der Durchätzung der darüberliegenden Schicht aus dem Material hoher Dielektrizitätskonstante bzw. dem ferroelektrischen Material. Dadurch wird eine Eintiefung in der Dielektrizitätsschicht bis auf eine Restschichtdicke erreicht, die vorzugsweise kleiner oder gleich der Restdicke der Maskenschicht nach dem Ätzschritt ist.

Erfindungsgemäß wird daraufhin die Eintiefung lateral versiegelt durch Abscheidung einer Schicht aus O₃/TEOS-SiO₂ (TEOS steht für Tetraethylorthosilikat). Die hierbei erforderliche Prozeßtemperatur beträgt typischerweise 400°C und wird von der hochtemperaturbeständigen Lochmaskenschicht ohne Degradationseffekte toleriert.

Eine Oxidätzung legt daraufhin ähnlich wie bei einer Abstandhalter- bzw. Spacerätzung den Boden der Eintiefung frei, der daraufhin bis auf den Boden des Kontaktlochs durch Ätzen abgesenkt wird.

Die organische Schicht dient weiterhin als Lochmaske und wird anschließend entfernt.

Vorteilhafterweise folgt hierauf eine selektive erneute Abscheidung von O₃/TEOS-SiO₂ zur Versiegelung ausschließlich der Lateralwandung des Kontaktlochs und der Oberfläche der Scheibe unter Aussparung des Kontaktlochbodens. Hierauf folgt in an sich bekannter Weise eine Kontaktloch-Nachbehandlung zur Entfernung gegebenenfalls geschädigten Siliziumsubstrat-Materials und eine Metallisierung des Kontaktlochs.

Das erfindungsgemäße Verfahren läuft dadurch hinsichtlich des Lithographie-Prozesses einfacher ab als das herkömmliche Verfahren.

Nachfolgend wird die Erfindung anhand von Ausführungsbeispielen unter Bezugnahme auf die Zeichnungen beispielhaft näher erläutert.

Es zeigen:
- Fig. 1A bis 1D: schematisch die Schrittabfolge eines herkömmlichen Verfahrens zur Herstellung eines Halbleiterspeicherbauelements unter Verwendung von Materialien hoher Dieleketrizitätskonstante und von ferroelektrischen Materialien, und
- Fig. 2A bis 2G: schematisch die Schrittabfolge eines erfindungsgemäßen Verfahrens zur Herstellung eines Halbleiterspeicherbauelements unter Verwendung, von Materialien hoher Dielektrizitätskonstante und von ferroelektrischen Materialien.

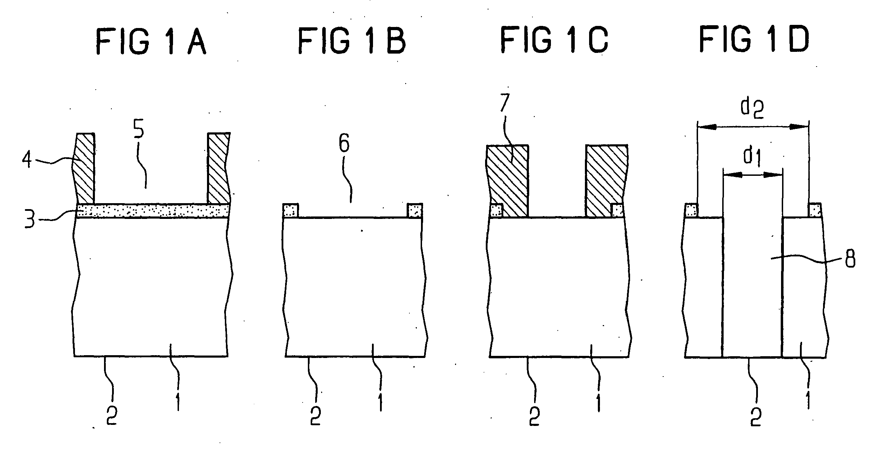

Zum besseren Verständnis der Erfindung wird zunächst anhand von Fig. 1A bis 1D ein herkömmliches Verfahren zur Herstellung eines Halbleiterspeicherbauelements unter Verwendung von Materialien hoher Dielektrizitätskonstante und von ferroelektrischen Materialien erläutert. Dieses herkömmliche Verfahren erfordert den Einsatz von zwei Lithographie-Ebenen bzw. Lithographie-Schritten.

Die erste Lithographie-Ebene ist in Fig. 1A und 1B gezeigt, und die zweite Lithographie-Ebene ist in Fig. 1C und 1D gezeigt. Gemäß diesen Figuren wird das Halbleiterspeicherelement aufgebaut aus einem Siliziumsubstrat, dessen genaue Struktur nicht gezeigt ist, und auf welchem eine DielektrikumSchicht 1 angeordnet ist, die mit ihrer Unterseite an die Oberseite des Siliziumsubstrats angrenzt. Diese Grenzschicht ist in Fig. 1A bis 1D allgemein mit der Bezugsziffer 2 bezeichnet.

An die Oberseite der Dielektrikumschicht 1 grenzt eine in Fig. 1A durchgehende Schicht hoher Dielektrizitätskonstante (oder eine ferroelektrische Schicht) an, die allgemein mit der Bezugsziffer 3 bezeichnet ist. Die Schicht 3 besteht beispielsweise aus BST (BST steht für Barium-Strontium-Titanat). Eine ferroelektrische Schicht 3 hingegen besteht beispielsweise aus SBT (SBT steht für Strontium-Wismuth-Tantalat).

Die Oberseite der Schicht 3 mit hoher Dielektrizitätskonstante ist zunächst vollständig abgedeckt durch eine Lackschicht 4. Diese Lackschicht 4 wird in bekannter Weise in eine Lackmaske (Lochmaske 4) überführt, die eine Vielzahl von Öffnungen 5 aufweist. Die Öffnung 5 dient zur Ätzung eines Fensters 6 in die Schicht 3 hoher Dielektrizitätskonstante, wie in Fig. 1B gezeigt, die bereits das Ergebnis des nächsten Verfahrensschritts zeigt, der in der Entfernung der Lackschicht 4 resultiert. Dieser Lackentfernungsschritt ist auch als Lackstrippen bekannt.

Wie in Fig. 1C gezeigt, wird auf die Oberflächenstruktur von Fig. 1B wiederum eine Lackschicht aufgetragen, die allgemein mit der Bezugsziffer 7 bezeichnet ist und in bekannter Weise in eine Lackmaske überführt wird, die Durchbrüche an den Stellen aufweist, an denen in die Dielektrikumschicht 1 ein Kontaktloch eingebracht werden soll. Erzeugt wird dieses Kontaktloch mittels der zweiten Lithographie-Ebene durch Ätzung der Dielektrikumschicht 1 unter Zuhilfenahme der Lackmaske bis zur Grenzschicht 2, wie in Fig. 1D gezeigt, die bereits das Resultat des nächsten Schritts darstellt, demnach die Lackschicht 7 vollständig entfernt ist.

Bei den vorstehend erläuterten Ätzschritten handelt es sich üblicherweise um Plasmaätzen.

Das Kontaktloch, das allgemein mit der Bezugsziffer 8 bezeichnet ist, hat eine typische Strukturgröße bzw. einen Durchmesser d₁ von 0,6 µm und ist damit ungefähr halb so groß wie das Fenster 6 mit dem Durchmesser d₂. Diese Dimensionen sind jedoch nicht zwingend, sondern nur beispielhaft gewählt.

Durch die in Fig. 1A bis 1D zum Ausdruck kommenden Verfahrensschritte wird erreicht, daß der Boden des Kontaktlochs 8 (Fig. 1D), d.h., die durch dieses Kontaktloch freiliegende Oberfläche des monokristallinen Siliziumsubstrats (Grenzfläche 2) nicht kontaminiert wird. Bei einer direkten Ätzung (d.h. bei Verwendung einer einzigen Lithographiemaske) bis zum Si wäre das Plasma kontaminiert und somit auch das einkristalline Siliziumsubstrat. Um eine negative Beeinflussung der Funktion des Halbleiterspeicherbauelements zu verhindern, darf das Siliziumsubstrat nicht kontaminiert werden.

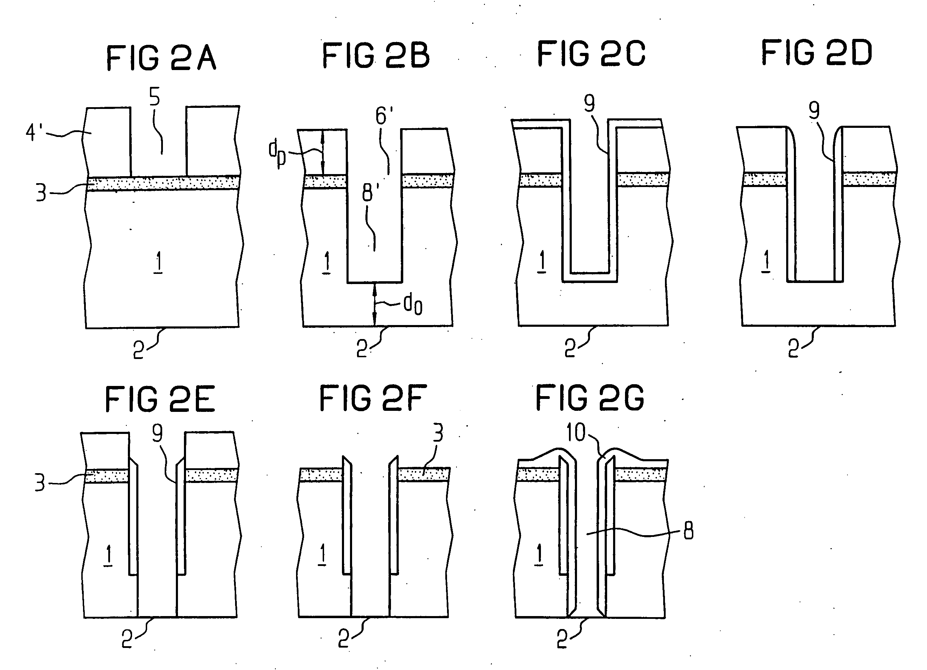

Das erfindungsgemäße Verfahren zur Herstellung des in Rede stehenden Halbleiterspeicherbauelements wird nunmehr anhand von Fig. 2A bis 2G erläutert. Das erfindungsgemäße Verfahren unterscheidet sich von dem vorstehend anhand von Fig. 1A bis 1D erläuterten Verfahren dadurch, daß eine Lithographie-Ebene bzw. ein Lithographie-Schritt eingespart wird. Das erfindungsgemäße Verfahren beruht demnach auf einer einzigen Lithographie-Ebene.

Soweit die in Fig. 2A bis 2G gezeigte Struktur derjenigen von Fig. 1A bis 1D entspricht, werden dieselben Bezugsziffern verwendet.

Fig. 2A entspricht Fig. 1A mit dem Unterschied, daß bei dem in Fig. 2A gezeigten Verfahrensschritt keine Maske aus herkömmlichem Lack verwendet wird, sondern eine allgemein mit 4' bezeichnete Maske aus einem organischen Material, wie etwa Polyimid bzw. Photoimid, wobei das Maskenmaterial beständig ist gegenüber einer im späteren Verfahrensschritt gemäß Fig. 2C abgeschiedenen Schicht aus O₃/TEOS-SiO₂.

Auf den Verfahrensschritt, der in Fig. 2A gezeigt ist, folgt der in Fig. 2B gezeigte Verfahrenschritt, bei dem unter Verwendung der Öffnung 5 sowohl die Schicht 3 hoher Dielektrizitätskonstante wie auch eine Eintiefung 8' in die Dielektrikumschicht 1 geätzt werden, die auch als Teilätzung im Sinne des Kontaktlochs 8 von Fig. 1D bezeichnet werden kann. Bei dem in Fig. 2B gezeigten Ätzschritt wird außerdem die Maskenschicht 4' soweit abgetragen, daß eine Maskenschichtdicke dₚ verbleibt, die größer ist als die Restdicke d₀ zwischen der Sohle der Eintiefung 8' und der Grenzfläche 2 zum Siliziumsubstrat. Für die nachfolgenden Prozeßschritte ist es vorteilhaft, wenn die Lochmasken-Restdicke dₚ größer oder gleich wie die Dielektrikum-Restdicke d₀: dₚ ≥ d₀ ist. Letzteres ist jedoch nicht zwingend erforderlich, sondern nur beispielhaft. Wesentlich ist, daß die Selektivität des folgenden Ätzschrittes erlaubt, d₀ mit einer Maske der Dicke dₚ zu ätzen.

Im in Fig. 2C gezeigten nächsten Prozeßschritt wird auf die Struktur von Fig. 2B in hochkonformer Weise eine Schicht aus O₃/TEOS-SiO₂ abgeschieden, welche auch die Eintiefung 8' auskleidet. Diese Schicht ist mit der Bezugsziffer 9 bezeichnet. Zweck der Schicht 9 ist eine laterale bzw. seitliche Versiegelung der Schicht 3 mit hoher Elektrizitätskonstante im Bereich 6' und der Dielektrikumschicht 1 im Bereich der Eintiefungswände. Die Prozeßtemperatur bei der Abscheidung der Schicht 9 beträgt typischerweise 400°C und wird von der hochtemperturbeständigen Schicht 4' ohne Degradationseffekte toleriert.

Wie in Fig. 2D dargestellt, folgt als nächster Prozeßschritt eine erneute Ätzung ähnlich wie bei einer Abstandhalterätzung zur Freilegung der Oberseite der Lochmaskenschicht 4' sowie des Bodens der Eintiefung 8'. Während dieses Ätzprozesses wird auch der obere Rand des Lochs in der Schicht 4' gekürzt. Wie in Fig. 2E gezeigt, wird dieser Ätzprozeß solange fortgeführt, bis der Boden der Eintiefung 8' die Grenzfläche 2 zum Siliziumsubstrat erreicht hat. Daraufhin wird, wie in Fig. 2F gezeigt, die Schicht 4' entfernt (Strippen).

Daraufhin wird selektiv erneut O₃/TEOS-SiO₂ abgeschieden, wie in Fig. 2G gezeigt und mit der Bezugsziffer 10 bezeichnet. Diese selektive O₃/TEOS-SiO₂-Abscheidung ist im einzelnen im deutschen Patent Nr. 19 528 746 erläutert, demnach ausschließlich die Oberseite der Schicht 3 hoher Dielektrizitätskonstante und die Seitenwand des Kontaktlochs 8 beschichtet wird, während am Boden des Kontaktlochs 8 keinerlei Abscheidung erfolgt. Hieran schließt sich ein nicht dargestellter Prozeßschritt an, demnach das Kontaktloch 8 nachbehandelt wird, um gegebenenfalls geschädigtes Material des Siliziumsubstrats am Boden des Kontaktlochs zu entfernen und das Kontaktloch zu metallisieren.

Das in Fig. 2A bis 2G gezeigte erfindungsgemäße Verfahren erlaubt demnach in einer einzigen Lithographie-Ebene die Einbringung eines Kontaktlochs ohne Kontamination des einkristallinen Siliziumsubstrates am Boden des Kontaktlochs.

## Patentansprüche

1. Verfahren zur Herstellung eines Kontaktlochs für ein Halbleiterspeicherbauelement, insbesondere ein DRAM oder ein FRAM, mit einem Siliziumsubstrat, einer auf diesem angeordneten Zwischendielektrikumschicht (1), auf welcher eine obere Schicht (3) aus einem ferroelektrischen Material oder aus einem Material hoher Dielektrizitätskonstante angeordnet ist, mit den Schritten:
Bilden einer Lochmaske auf der oberen Schicht (3), wobei für die Lochmaske ein Material verwendet wird, welches eine Temperaturbeständigkeit bei einem späteren Abscheidungsprozeß aufweist;
Ätzen der oberen Schicht (3) und einer Eintiefung (8') in die Zwischendielektrikumschicht (1) bis zu einer Restdicke (d₀) mittels der Lochmaske;
Abscheiden einer Schicht aus O₃/TEOS-SiO₂ auf die derart gewonnene Struktur einschließlich der Lochmaske in dem späteren Abscheidungsprozeß;
Entfernen der Schicht aus O₃/TEOS-SiO₂ vom Boden der Eintiefung (8') durch Ätzen; und
Absenken der Eintiefung (8') daraufhin durch Ätzen zur Erzeugung des Kontaktloches bis zur Grenzfläche zum Siliziumsubstrat unter Freilegung desselben, wobei die Schicht aus O₃/TEOS-SiO₂ beim Ätzen als seitliche Versiegelung der oberen Schicht (3) dient.

2. Verfahren nach Anspruch 1, **dadurch gekennzeichnet, daß** als Material für die Lochmaske Polyimid verwendet wird.

3. Verfahren nach Anspruch 1, **dadurch gekennzeichnet, daß** als Material für die Lochmaske Photoimid verwendet wird.

4. Verfahren nach Anspruch 1, 2 oder 3, **dadurch gekennzeichnet, daß** nach Freilegung des Siliziumsubstrats im Bereich des Kontaktlochbodens unter Aussparung desselben erneut eine Schicht aus O₃/TEOS-SiO₂ auf diese Struktur abgeschieden wird.

5. Verfahren nach Anspruch 4, **dadurch gekennzeichnet, daß** vor erneuter Abscheidung von O₃/TEOS-SiO₂ das Lochmaskenmaterial gestrippt wird.

6. Verfahren nach einem der vorhergehenden Ansprüche, **dadurch gekennzeichnet, daß** als obere Schicht (3) eine Schicht aus SBT, PZT, oder BST verwendet wird.

## Claims

1. A method of manufacturing a contact opening for a semiconductor memory device, in particular a DRAM or a FRAM, comprising a silicon substrate on which an inter-dielectric layer (1) is arranged, on which a top layer (3) made of a ferro-electric material or a material having a high dielectric constant is arranged, comprising the steps of:
- forming an aperture mask on the top layer (3), wherein a material is used for the aperture mask which endures a temperature in a later deposition process;
- etching at a top layer (3) and a recess (8') into the inter-dielectric layer (1) down to a residual thickness (d₀) using the aperture mask;
- depositing a layer of O₃/TEOS-SiO₂ on the formed structure including the aperture mask in said later deposition process;
- removing of the layer of O₃/TEOS-SiO₂ from the bottom of the recess (8') by means of etching; and
- thereafter indenting the recess (8') by etching for forming the contact opening to the interface surface of the silicon substrate and exposing the same; wherein the layer of O₃/TEOS-SiO₂ serves as a side seal of the top layer (3) during the etching process.

2. The method according to claim 1, **characterized in that** polyimide is used as material for the aperture mask.

3. The method according to claim 1, **characterized in that** photoimide is used as material for the aperture mask.

4. The method according to one of claims 1, 2 or 3, **characterized in that** after exposing the silicon substrate in the area of a contact opening bottom excluding the same, a layer of O₃/TEOS-SiO₂ is newly deposited on this structure.

5. The method according to claim 4, **characterized in that** the material of the aperture mask is stripped before newly depositing of O₃/TEOS-SiO₂.

6. The method according to one of the preceding claims, **characterized in that** a layer of one of SBT, PCT, and BST is used as top layer (3).

## Revendications

1. Procédé pour la fabrication d'un trou de contact pour un composant mémoire semi-conducteur, en particulier une DRAM ou FRAM, comprenant un substrat de silicium, sur lequel une couche diélectrique intermédiaire (1) est disposée, sur laquelle une couche supérieure (3) en matériau ferroélectrique ou en matériau à haute constante diélectrique est disposée, comprenant les étapes :
formation d'un masque à trous sur la couche supérieure (3), un matériau ayant une constance thermique dans un procédé de dépôt ultérieur étant utilisé pour le masque à trous ;
gravure de la couche supérieure (3) et d'un creusement (8') dans la couche diélectrique intermédiaire (1) jusqu'à une épaisseur restante (d₀) à l'aide du masque à trous ;
dépôt d'une couche en O₃/TEOS-SiO₂ sur la structure ainsi obtenue incluant le masque à trous dans le procédé de dépôt ultérieur ;
retrait de la couche en O₃/TEOS-SiO₂ du fond du creusement (8') par gravure ; et
approfondissement du creusement (8') par gravure jusqu'à l'interface avec le substrat de silicium en le dégageant pour la génération d'un trou de contact, la couche en O₃/TEOS-SiO₂ servant, lors de la gravure, de vitrification latérale de la couche supérieure (3).

2. Procédé selon la revendication 1, **caractérisé en ce que** du polyimide est utilisé comme matériau pour le masque à trous.

3. Procédé selon la revendication 1, **caractérisé en ce que** du photoimide est utilisé comme matériau pour le masque à trous.

4. Procédé selon la revendication 1, 2 ou 3 **caractérisé en ce qu'**après le dégagement du substrat de silicium, une nouvelle couche en O₃/TEOS-SiO₂ est déposée sur cette structure au niveau du fond du trou de contact en évitant celui-ci.

5. Procédé selon la revendication 4 **caractérisé en ce qu'**avant le nouveau dépôt de O₃/TEOS-SiO₂, le matériau de masque à trous est strippé.

6. Procédé selon l'une quelconque des revendications précédentes **caractérisé en ce qu'**une couche en SBT, PZT ou BST est utilisée comme couche supérieure (3).
